# EUROPEAN PATENT SPECIFICATION

(11) **EP 3 331 000 B1**
(45) Date of publication and mention of the grant of the patent: **24.11.2021**
(21) Application number: 17275192.7
(22) Date of filing: 04.12.2017
(51) Int. Cl.: H01L 21/3065, H01L 21/768

(54) **METHOD OF SMOOTHING A SURFACE**
VERFAHREN ZUM GLÄTTEN EINER OBERFLÄCHE
PROCÉDÉ DE LISSAGE D'UNE SURFACE

(30) Priority: 05.12.2016 GB 201620680
(43) Date of publication of application: 06.06.2018
(73) Proprietor: SPTS Technologies Limited, Newport Gwent NP18 2TA (GB)
(72) Inventor: MUMFORD, Roland, Cardiff, South Glamorgan CF14 1RF (GB)
(74) Representative: Wynne-Jones IP Limited

(56) References cited:
- US-A1- 2003 062 335
- US-A1- 2015 287 637
- ZAROWIN C B: "Comparison of the smoothing and shaping of optics by plasma-assisted chemical etching and ion milling using the surface evolution theory", APPLIED OPTICS, OPTICAL SOCIETY OF AMERICA, WASHINGTON, DC; US, vol. 32, no. 16, 1 June 1993 (1993-06-01), pages 2984-2991, XP002406264, ISSN: 0003-6935, DOI: 10.1364/AO.32.002984

## Description

This invention relates to a method of smoothing a surface of a silicon substrate.

In many semiconductor applications, it is desirable to manufacture devices on thin silicon substrates. The reasons for this desirability include form factor and performance considerations. In practice, the device is typically formed on a conventional silicon wafer. For example, a 300mm diameter silicon wafer is typically about 765 microns thick. Once the device manufacture steps are completed, the wafer is ground down to the final device thickness using conventional grinding equipment. The rate of removal and surface finish can be controlled by standard procedures, although both factors are dependent on the grinding wheels and the abrasives used. Once the grinding step is completed, the grounded surface is polished to meet the required specification of the device manufacturer. The polishing step can also remove material that has been damaged by the aggressive grinding operation. In turn, this can improve the mechanical properties of the substrate and the eventually produced die.

With vertically stacked semiconductor dies, wafers are ground back to remove the bulk of the wafer thickness before integrating devices in a three dimensional stack. In some schemes, such as through silicon vias (TSVs), the buried copper TSVs are revealed by a plasma or wet etch 'via reveal' step which follows the removal of bulk silicon in the grinding step.

The grinding process produces radial scratch patterns that are visible both to the eye and also to inspection equipment. This can result in spurious defect detection and hence loss of yield. The scratches are less than 100nm in depth, but are reasonably visible to the naked eye. Therefore, it is necessary to improve the surface finish of the ground wafer to enable the subsequent use of conventional optical inspection equipment. Current solutions to this problem rely on chemical and mechanical planarization (CMP) to remove scratches before a plasma etching step. The CMP process is expensive, time consuming, and suffers from repeatability problems. One study suggests that almost 50% of the cost of TSV reveal processes are associated with CMP (http://www.3dincites.com/2016/03/cost-analysis-of-a-wet-etch-tsv-reveal-process/).

From the forgoing discussion, it can be seen that there is a need to eliminate the CMP step in the processing of ground silicon substrates. This would have the desirable effect of eliminating the associated and expensive CMP equipment and consumables. The problem is to eliminate the CMP step whilst obtaining at least acceptable smoothness of the processed silicon substrate.

Zarowin C. B., Applied Optics, 1993, vol. 32, no. 16, pp. 2984-2991 discloses a comparison of the smoothing and shaping of optics by plasma-assisted chemical etching and ion milling using the surface evolution theory.

US2003/0062335 A1 discloses a process for smoothing a rough surface on a substrate by dry etching.

US2015/0287637 A1 discloses a method for etching a semiconductor substrate to reveal one or more features buried in the substrate.

The present invention, in at least some of its embodiments, addresses the above described desires and problems.

According to a first aspect of the invention there is provided a method of smoothing a surface of a silicon substrate comprising the steps of:
providing a silicon substrate having a backside surface, wherein the silicon substrate has been ground to leave the backside surface with an associated roughness: and
smoothing the backside surface of the silicon substrate using a plasma etch process;
in which the plasma etch process comprises the steps of:
   performing a first plasma etch step which forms a plurality of protrusions that upstand from the backside surface, wherein the first plasma etch step is an isotropic etch process which uses a gas mixture comprising oxygen and a fluorine containing etchant precursor gas, and which uses flows of the fluorine containing etchant precursor gas and oxygen which have associated flow rates, and the flow rate of oxygen is greater than the flow rate of the fluorine containing etchant precursor gas, and wherein no RF bias or an RF bias power of less than 100 W is used during the first plasma etch step; and
   performing a second plasma etch step which at least partially etches the protrusions to provide a smoothed backside surface which exhibits specular reflection, wherein the second plasma etch step (120) uses a fluorine containing etchant precursor gas or a chlorine containing etchant precursor gas, and wherein an RF bias power of greater than 500 W is used during the second plasma etch step (120), and
   in which the first and second plasma etch steps are alternately repeated.
   In this way, it is possible to avoid an undesirable CMP step whilst delivering at least acceptable results. In general, the invention is performed without performing a CMP step.

Typically, the second etch step is performed to substantially remove the protrusions.

The first and second plasma etch steps are alternately repeated any number of times to achieve a desired finish.

The first plasma step is an isotropic etch process.

The flow rate of oxygen may be at least three times the flow rate of the etchant precursor gas. The flow rate of oxygen used in relation to the flow rate of the etchant precursor gas may be selected so as to ensure that polymeric species are not deposited on the substrate during the first etch step.

The first plasma etch step uses a fluorine containing etchant precursor gas. The fluorine containing etchant precursor gas may be SF₆. Alternatively, the fluorine containing etchant precursor gas may be CF₄.

The first plasma etch step may be performed at a pressure in the range 100-500 mTorr.

The first plasma etch step may produce a plurality of deposits on the back side surface which act to mask the protrusions.

The second plasma etch step may use a fluorine containing etchant precursor gas. The fluorine containing etchant precursor gas may be SF₆ or CF₄. Chlorine based etch chemistries may be employed in the second etch step. In these embodiments the second plasma etch step uses a chlorine containing etchant precursor gas.

The second etch step may be performed in the substantial absence of oxygen.

The second plasma etch step may use a Noble gas as a process gas. The Noble gas may be argon. Without wishing to be limited by any particular theory or conjecture, it is believed that the sputtering associated with the Noble gas may enhance the removal of any deposits on the back side surface which act to mask the protrusions.

An RF bias power is used during the second plasma etch step. The RF bias power used during the second plasma etch step is greater than 500W. Preferably, the RF power used is greater than 700W.

In embodiments in which the first and second plasma etch steps are alternately repeated, the etch conditions associated with the first etch step and/or the second etch step may remain the same. Examples of etch conditions comprise RF source power, gas flow rates, etch time and gas pressure. However, it is also within the scope of the invention for the etch conditions associated with the first etch step and/or the second etch step to change as the plasma etch process proceeds. The skilled reader will appreciate that there are an unlimited number of variations possible. In general, a plasma etch process is selected to best match any given end application and system. For example, the first etch step and/or the second etch may change smoothly over the course of the plasma etch process by smoothly varying one or more of the associated etch conditions. Alternatively, or additionally, there may be an abrupt change in the first and/or second etch step by abruptly varying one or more of the associated etch conditions.

The first plasma etch step may comprise two or more different first etches, wherein each of the first etches has different associated etch conditions. Additionally, or alternatively, the second plasma etch step may comprise two or more different second etches, wherein each of the second etches has different associated etch conditions. One of the second etches may be a polish etch step. The polish etch step may at least partially etch the protrusions at a higher etch rate than the others of the second etches. The polish etch step may be performed using a higher gas pressure than the others of the second etches. The polish etch step may be similar to or identical to the process described in the Applicant's patent application US 2015/0287637 for revealing features such as vias buried in a silicon substrate.

In general, the polish etch step is performed as the last second etch step. This may be achieved by providing a polish etch step as a discrete second etch step at the end of the plasma etch process. Alternatively, the first and second etch steps may be alternately repeated so that the second plasma etch step comprises two or more different second etches, and the last of the second etches performed is a polish etch step.

The plasma etch process may reduce the thickness of the substrate by 2.5 microns or less.

The plasma etch process results in a reduction of the thickness of the substrate. The first plasma etch step may account for less than 20% of the reduction.

Prior to the step of smoothing, the backside surface may have a topography with a height variation of 100nm or less.

The step of smoothing may be performed so that the backside surface has a topography with a height variation of 25 nm or less.

The silicon substrate provided may have a periodic scratch pattern on the backside surface. The step of smoothing may be performed so as to remove the periodic scratch pattern. The periodic scratch pattern may comprise a plurality of grooves which are imparted by the grinding process used previously to grind the silicon substrate.

The substrate may contain buried features such as vias. The method may further comprise the step of performing a buried feature reveal process subsequent to the step of smoothing. Advantageously, the steps of smoothing and performing the buried feature reveal process may be performed sequentially in a common chamber. It is a considerable advantage of the invention that it is possible to perform sequential smoothing and buried feature reveal processes on a silicon substrate disposed in a common chamber with the substrate remaining in the common chamber between the step of smoothing and the step of performing a buried feature reveal process.

The protrusions may present themselves as spires of silicon.

The protrusions may present themselves as grass-like formations.

Typically, the silicon substrate is a silicon wafer. A wafer of any desired diameter might be used.

Generally, the silicon substrate provided has a front side surface with one or more device structures formed thereon.

According to a second aspect that is not part of the invention as claimed, there is provided an apparatus for smoothing a surface of a silicon substrate using a method according to a first aspect of the invention, the apparatus comprising:
a chamber in which the plasma etch process is performed;
one or more plasma production devices for producing plasmas suitable for performing the first and second plasma etch steps; and
a controller configured to control the apparatus to perform the method according to the first aspect of the invention.

Whilst the invention is described above, it extends to any inventive combination of the features set out above or in the following description, drawings or claims. For example, any feature described in relation to the first aspect of the invention is also disclosed in combination with the second aspect of the invention and *vice versa.*

The invention may be performed in various ways, and, by way of example only, embodiments thereof will now be described with reference to the accompanying drawings, in which:-
Figure 1 shows steps in an embodiment of the invention;
Figure 2 shows (a) an image and (b) a SEM micrograph of the surface of a ground silicon wafer;
Figure 3 shows (a) a two dimensional view and (b) a three dimensional representation of the surface of the silicon wafer after a first etch step to produce protrusions;
Figure 4 shows (a) a two dimensional view and (b) a three dimensional representation of the surface of the silicon wafer after a cyclical etch process comprising alternate first and second etch steps;
Figure 5 (a) and (b) shows SEM micrographs of a cross section of the silicon wafer after the cyclical etch treatment;
Figure 6 shows optical micrographs of (a) the surface of the ground silicon wafer prior to etch treatment of the invention and (b) the surface of the silicon wafer after the etch treatment of the invention; and
Figure 7 shows an embodiment in which wafer smoothing by etching is combined with a via reveal process.

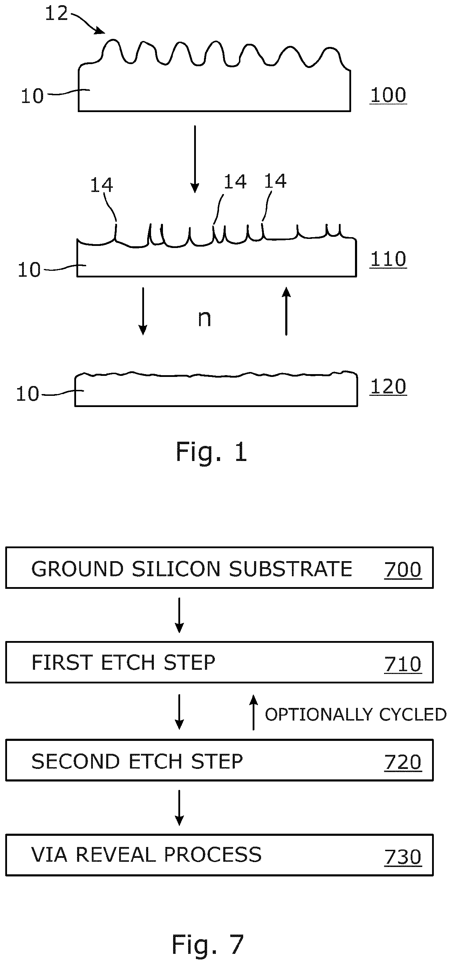

Figure 1 depicts steps in a process of the invention. In a first step 100, a silicon substrate 10 is supplied for processing. Typically, the silicon substrate is a wafer. The substrate 10 is a thinned substrate which has been thinned by grinding. This grinding process imparts a surface roughness 12. The invention provides a way of smoothing the surface roughness using a plasma etch process which is described below.

In a first plasma etch step 110, the rough surface of the substrate 10 is etched to produce a plurality of protrusions 14. Then, in a second etch step 120, the protrusions are etched back to provide a surface16 which is smoother than the surface of the thinned substrate prior to commencement of the etch process.

According to the invention it is performed a looped, or cyclical etch process where the first and second etch steps are alternately repeated a number of times. In Figure 1, this is shown as n cycles. There is no fundamental limitation on the number n of cycles performed- this will be determined process optimisation for any given process scenario.

By way of example only, process conditions will now be described for an embodiment of the invention. In this embodiment, both the first and second etch steps use SF₆ as a process gas. Whilst this is convenient from a process point of view, it is not necessary that common process gases are used in the first and second etch steps. In the first etch step, an oxygen rich mixture of SF₆, oxygen and a trace amount of argon is used. No RF bias is applied and a relatively high pressure of 250 mTorr is used. The first etch step is isotropic. In the second etch step, a mixture of SF₆, argon and a trace amount of oxygen is used. An RF bias is applied and a substantially lower pressure of 20 mTorr is used. The process conditions are shown in Table 1.

**Table 1. Typical process conditions for a looped process.**

| Process Condition | Strike | Second Etch Step | First Etch Step |
|---|---|---|---|
| Pressure (mT) | 20 | 20 | 250 |
| RF Source (kW) | 1.5 | 1.5 | 2.5 |
| RF bias (kW) | 0 | 0.75 | 0 |
| Process Gas - Ar (sccm) | 400 | 400 | 1 |
| Process Gas - SF6 (sccm) | 150 | 150 | 100 |
| Process Gas - O2- (sccm) | 1 | 1 | 500 |

In this example the RF source power, gas flows, and gas pressure all remain the same between the loops. However, they could be different for different loops or change over the total time of the process. Table 1 merely details some typical process conditions used for this process. For example, the looped process can be applied to lower power and/or gas flow conditions.

The loop times can be chosen to achieve the optimal ratio for initial roughness. Typical loop times are 30s for the first etch step and 10s for the second etch step. However, a range of 2s to 600s for the loop times is believed to be practical. The RF bias power used could be at a continuous level or pulsed. Other parameters such as RF source power and gas flows might be at a continuous level or pulsed. The process times of the individual etch steps and bias powers could also change as a function of the total process time. The process can be carried out using known etch tools which can be adapted using the teachings provided herein to perform the invention. The applicant's own Pegasus etch module can be adapted in this way.

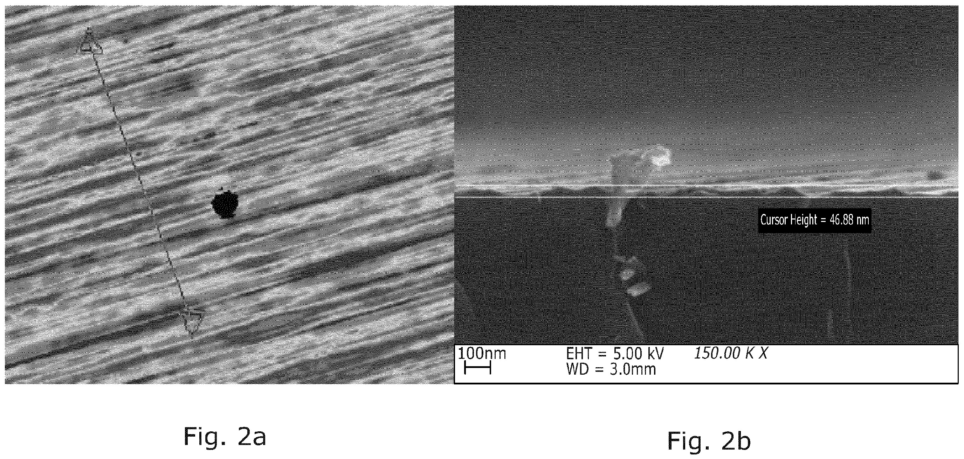

Ground silicon wafers were processed in accordance with the invention and their surface characteristics analysed. Silicon wafers of 300mm diameter were used in these experiments. The surface roughness of the incoming ground wafers was characterised using a Zygo white light interferometer and by SEM (scanning electron microscopy) using cleaved pieces of wafers. In Figure 2(a) we can see the optical appearance of a silicon wafer after the grind step. In Figure 2(b) the SEM micrograph clearly shows the grind marks on the wafer surface with a range of ~47nm. Wafers with local roughness of up to ~100nm have been processed successfully. Periodic grooves on the surface are clearly recognisable. These grooves are imparted during the grinding process. The grooves are visible to the naked eye and, importantly, to conventional inspection equipment. This can give rise to spurious defect detection unless steps are taken to improve the surface roughness- in particular to reduce or eliminate the pattern of grooves.

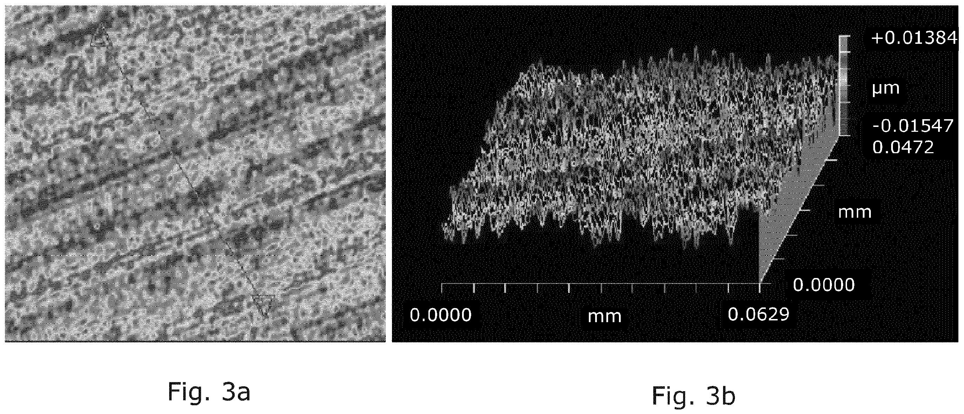

Figures 3(a) and (b) show the wafer surface after a first etch step has been performed. This step can be regarded as a surface-roughening step, and it results in the creation of a plurality of protrusions. This can be seen in Figure 3 as a large number of fine spires of silicon, in this case of the order of 30nm high. To highlight the features these measurements were made after a prolonged 5min surface roughening step. This gives the silicon surface a 'grassy' appearance. The creation of the 'grassy' surface is a mechanism by which the regular scratch pattern previously created by grinding can be disrupted. The second etch step can be regarded as a break-through step which polishes the surface through reduction of the roughened surface.

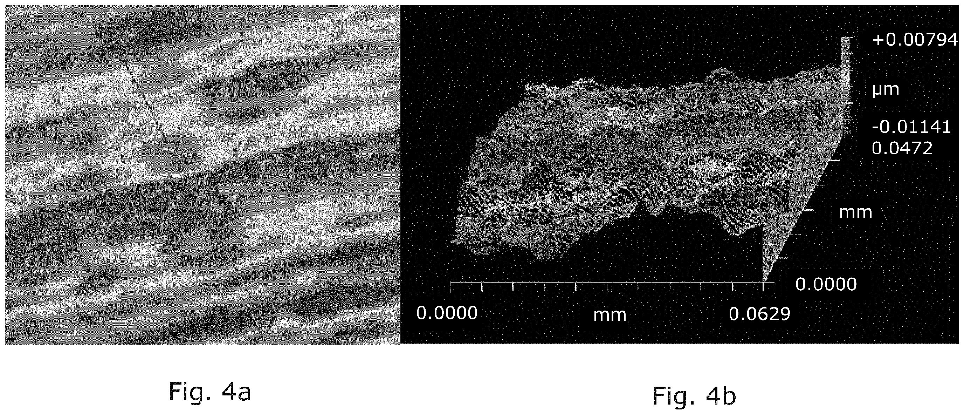

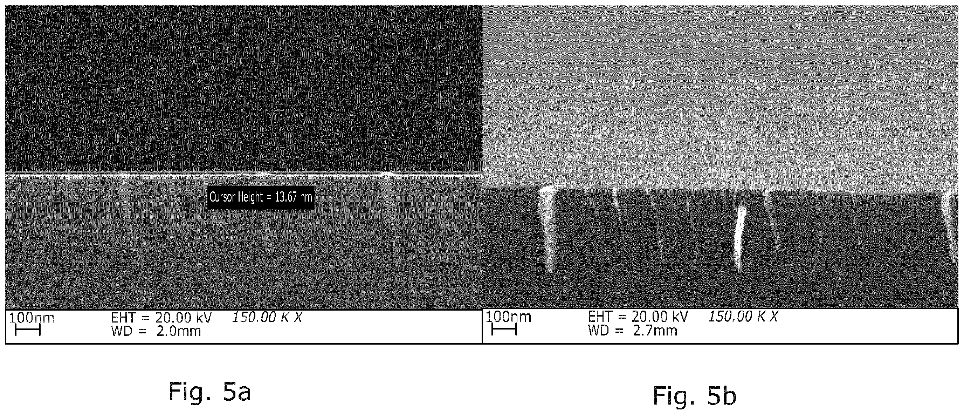

By repeating this process for a variable number of loops depending on initial surface roughness, a visually smooth (no scratches visible by eye) surface is created. Figures 4(a) and (b) show the wafer surface after receiving a number of loops of the process. There are no visible spires of silicon and whilst the roughness is still around 20nm the grooves caused by grinding have merged and no scratches are seen by eye. As noted previously, this criterion was chosen as this optically smooth surface is needed to pass automated inspection equipment which mistakes grind marks as process defects. SEM cross sections of post etch surfaces at an equivalent magnification to that used in Figure 2(b) (150kX) are presented in Figure 5 (a) and (b). These images show a virtually featureless surface with topography < 14nm in height. The original grind pattern has been dramatically reduced resulting in a specular wafer surface which has improved reflectivity.

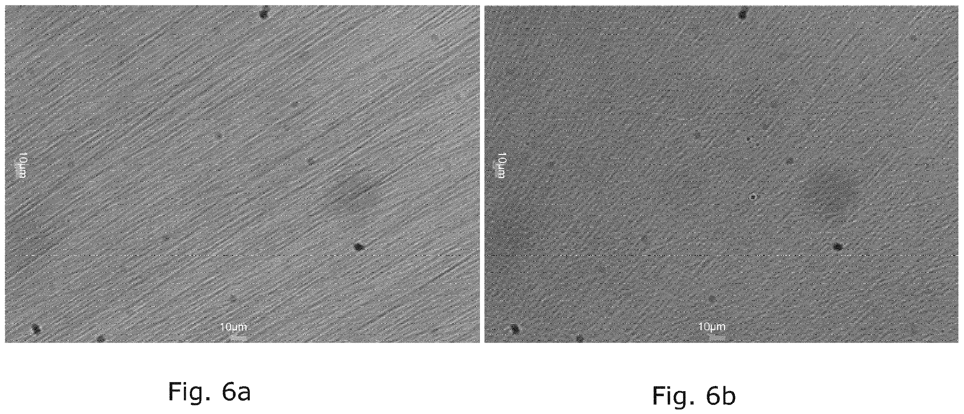

Figures 6 (a) and (b) shows optical micrographs of the surface topography of the wafer before and after the etch smoothing process is employed. This confirms that the randomization of scratches on the surface eliminates visible scratches. As a consequence of this process standard automated inspection equipment do not mistakenly identify the treated ground surface as defective.

Typically, around 2 microns of silicon is removed using the etch process, with about 0.3 micron being removed due to the first (grass formation) etch step. Etch rates of >1.2mm / min are achievable. However, these values are representative only. It is possible that the smoothing provided by the invention may also provide some stress relief for the substrate as well.

Without wishing to be bound by any particular theory or conjecture, we speculate that the protrusions are formed during the surface roughening step due to micromasking. Further, we speculate that the micromasking features are non-polymeric in nature and are caused by sulphur containing compound(s). By operating at a relatively high pressure in an oxygen rich environment with little or no RF bias, it is believed that the plasma chemistry is non-polymeric. It is believed also that this is a favorable regime for controlling the density of the micromasking features. The etch step uses lower pressure and RF bias coupled with Ar to help remove the micromasking materials and provide SF6 to remove silicon.

As mentioned above, the etch conditions associated with the first etch step and/or the second etch step may change as the plasma etch process proceeds. The skilled reader will appreciate that there are an unlimited number of variations possible and, in general, a plasma etch process is selected to best match any given end application and system. Also, within a loop, the first plasma etch step may comprise two or more different first etches, wherein each of the first etches has different associated etch conditions. Additionally, or alternatively, within a loop the second plasma etch step may comprise two or more different second etches, wherein each of the second etches has different associated etch conditions. In a non-limiting example, a process of the invention may comprise n loops, where each loop is made up of first etch 1A, second etch 2A, first etch 1B and second etch 2B, performed in that order. Etches 1A and 1B together comprise the first plasma etch step, whereas etches 2A and 2B together comprise the second plasma etch step. One of the second etches (preferably the second etch 2B) may be a polish etch step which etches the protrusions at a higher etch rate than the others of the second etches. Other variations (using loops comprising fewer or more etches) will suggest themselves to the skilled reader. The polish etch step may be similar to or identical to the process described in the Applicant's patent application US 2015/0287637. In general, the polish etch step is performed as the last second etch step.

Figure 7 shows an advantageous aspect of the invention in which the substrate contains buried features such as vias. In this aspect, smoothing of the substrate surface is combined with a via reveal process, with all of the steps being performed in a single chamber of a single process tool. This provides significant processing advantages. In a first step 700, a thinned silicon substrate is supplied for processing. In a first plasma etch step 710, the rough surface of the substrate is etched to produce a plurality of protrusions 14. In a second etch step 720, the protrusions are etched back to provide a surface which is smoother than the surface of the thinned substrate prior to commencement of the etch process. Then, a process 730 is performed in the same chamber in which silicon is removed to reveal the buried features. An example of a suitable process for revealing buried features is described in the Applicant's patent application US 2015/0287637.

## Claims

1. A method of smoothing a surface of a silicon substrate (10) comprising the steps of:
providing a silicon substrate (10) having a backside surface, wherein the silicon substrate has been ground to leave the backside surface with an associated roughness (12); and
smoothing the backside surface of the silicon substrate (10) using a plasma etch process;
in which the plasma etch process comprises the steps of performing a first plasma etch step (110) which forms a plurality of protrusions (14) that upstand from the backside surface, wherein the first plasma etch step (110) is an isotropic etch process which uses a gas mixture comprising oxygen and a fluorine containing etchant precursor gas, and which uses flows of the fluorine containing etchant precursor gas and oxygen which have associated flow rates, and the flow rate of oxygen is greater than the flow rate of the fluorine containing etchant precursor gas, and wherein no RF bias or an RF bias power of less than 100 W is used during the first plasma etch step (110); and
performing a second plasma etch step (120) which at least partially etches the protrusions (14) to provide a smoothed backside surface which exhibits specular reflection, wherein the second plasma etch step (120) uses a fluorine containing etchant precursor gas or a chlorine containing etchant precursor gas, and wherein an RF bias power of greater than 500 W is used during the second plasma etch step (120), and
in which the first and second plasma etch steps are alternately repeated.

2. A method according to claim 1 in which the flow rate of oxygen is at least three times the flow rate of the etchant precursor gas.

3. A method according to claim 1 in which the fluorine containing etchant precursor gas of the first plasma etch step is SF₆ or CF₄.

4. A method according to claim 1 in which the fluorine containing etchant precursor gas of the second plasma etch step is SF₆ or CF₄.

5. A method according to any previous claim in which the second plasma etch step (120) is performed in the substantial absence of oxygen.

6. A method according to any previous claim in which the first plasma etch step (110) comprises two or more different first etches, wherein each of the first etches has different associated etch conditions and/or the second plasma etch step comprises two or more different second etches, wherein each of the second etches has different associated etch conditions.

7. A method according to any previous claim in which the second plasma etch step uses a Noble gas as a process gas, and optionally the process gas is argon.

## Patentansprüche

1. Verfahren zum Glätten einer Oberfläche eines Siliziumsubstrats (10), das folgende Schritte umfasst:
Bereitstellen eines Siliziumsubstrats (10), das eine rückseitige Oberfläche aufweist, wobei das Siliziumsubstrat geschliffen wurde, um die rückseitige Oberfläche mit einer zugehörigen Rauheit (12) zu belassen; und
Glätten der rückseitigen Oberfläche des Siliziumsubstrats (10) unter Verwendung eines Plasmaätzprozesses;
in dem der Plasmaätzprozess die Schritte eines Durchführens eines ersten Plasmaätzschritts (110) umfasst, der mehrere Vorsprünge (14) ausbildet, die von der rückseitigen Oberfläche aufrecht stehen, wobei der erste Plasmaätzschritt (110) ein isotroper Ätzprozess ist, der eine Gasmischung verwendet, die Sauerstoff und ein fluorhaltiges Ätzmittelvorläufergas umfasst, und der Ströme des fluorhaltigen Ätzmittelvorläufergases und Sauerstoff verwendet, die zugehörige Strömungsraten aufweisen, und wobei die Strömungsrate von Sauerstoff größer als die Strömungsrate des fluorhaltigen Ätzmittelvorläufergases ist, und wobei keine HF-Vorspannung oder eine HF-Vorspannungsleistung von weniger als 100 W während des ersten Plasmaätzschritts (110) verwendet wird; und
Durchführen eines zweiten Plasmaätzschritts (120), der die Vorsprünge (14) wenigstens teilweise ätzt, um eine geglättete rückseitige Oberfläche bereitzustellen, die eine spiegelnde Reflexion vorweist, wobei der zweite Plasmaätzschritt (120) ein fluorhaltiges Ätzmittelvorläufergas oder ein chlorhaltiges Ätzmittelvorläufergas verwendet, und wobei eine HF-Vorspannungsleistung von mehr als 500 W während des zweiten Plasmaätzschritts (120) verwendet wird, und
in dem der erste und der zweite Plasmaätzschritt abwechselnd wiederholt werden.

2. Verfahren nach Anspruch 1, in dem die Strömungsrate von Sauerstoff wenigstens das Dreifache der Strömungsrate des Ätzmittelvorläufergases beträgt.

3. Verfahren nach Anspruch 1, in dem das fluorhaltige Ätzmittelvorläufergas des ersten Plasmaätzschritts SF₆ oder CF₄ ist.

4. Verfahren nach Anspruch 1, in dem das fluorhaltige Ätzmittelvorläufergas des zweiten Plasmaätzschritts SF₆ oder CF₄ ist.

5. Verfahren nach einem der vorhergehenden Ansprüche, in dem der zweite Plasmaätzschritt (120) im Wesentlichen in Abwesenheit von Sauerstoff durchgeführt wird.

6. Verfahren nach einem der vorhergehenden Ansprüche, in dem der erste Plasmaätzschritt (110) zwei oder mehr unterschiedliche erste Ätzungen umfasst, wobei jede der ersten Ätzungen unterschiedliche zugehörige Ätzbedingungen aufweist und/oder der zweite Plasmaätzschritt zwei oder mehr unterschiedliche zweite Ätzungen umfasst, wobei jede der zweiten Ätzungen unterschiedliche zugehörige Ätzbedingungen aufweist.

7. Verfahren nach einem der vorhergehenden Ansprüche, in dem der zweite Plasmaätzschritt ein Edelgas als ein Prozessgas verwendet und optional das Prozessgas Argon ist.

## Revendications

1. Procédé de lissage d'une surface d'un substrat de silicium (10) comprenant les étapes consistant à :
fournir un substrat de silicium (10) ayant une surface arrière, dans lequel le substrat en silicium a été broyé pour laisser la surface arrière avec une rugosité associée (12) ; et
lisser la surface arrière du substrat de silicium (10) à l'aide d'un processus de gravure au plasma ;
dans lequel le processus de gravure au plasma comprend les étapes consistant à effectuer une première étape de gravure au plasma (110) qui forme une pluralité de saillies (14) qui se dressent depuis la surface arrière, la première étape de gravure au plasma (110) étant un processus de gravure isotrope qui utilise un mélange gazeux comprenant de l'oxygène et un gaz précurseur d'agent de gravure contenant du fluor, et qui utilise des flux du gaz précurseur d'agent de gravure contenant du fluor et de l'oxygène qui ont des débits associés, et le débit d'oxygène est supérieur au débit du gaz précurseur d'agent de gravure contenant du fluor, et dans lequel aucune polarisation RF ou une puissance de polarisation RF inférieure à 100 W n'est utilisée pendant la première étape de gravure au plasma (110) ; et
effectuer une seconde étape de gravure au plasma (120) qui grave au moins partiellement les saillies (14) pour fournir une surface arrière lissée qui présente une réflexion spéculaire, la seconde étape de gravure au plasma (120) utilisant un gaz précurseur d'agent de gravure contenant du fluor ou un gaz précurseur d'agent de gravure contenant du chlore, et dans lequel une puissance de polarisation RF supérieure à 500 W est utilisée pendant la seconde étape de gravure au plasma (120), et
dans lequel les première et seconde étapes de gravure au plasma sont répétées alternativement.

2. Procédé selon la revendication 1, dans lequel le débit d'oxygène est au moins trois fois le débit du gaz précurseur d'agent de gravure.

3. Procédé selon la revendication 1, dans lequel le gaz précurseur d'agent de gravure contenant du fluor de la première étape de gravure au plasma est SF₆ ou CF₄.

4. Procédé selon la revendication 1, dans lequel le gaz précurseur d'agent de gravure contenant du fluor de la seconde étape de gravure au plasma est SF₆ ou CF₄.

5. Procédé selon l'une quelconque des revendications précédentes, dans lequel la seconde étape de gravure au plasma (120) est effectuée en l'absence substantielle d'oxygène.

6. Procédé selon l'une quelconque des revendications précédentes, dans lequel la première étape de gravure au plasma (110) comprend deux ou plusieurs premières gravures différentes, dans lequel des premières gravures a des conditions de gravure associées différentes et/ou la seconde étape de gravure au plasma comprend deux ou plusieurs secondes gravures différentes, chacune des secondes gravures ayant des conditions de gravure associées différentes.

7. Procédé selon l'une quelconque des revendications précédentes, dans lequel la seconde étape de gravure au plasma utilise un gaz noble comme gaz de traitement, et éventuellement le gaz de traitement est de l'argon.
